Europäisches Patentamt

European Patent Office

Office européen des brevets

(11) Veröffentlichungsnummer: **0 374 707**
**A2**

---

(12) **EUROPÄISCHE PATENTANMELDUNG**

(21) Anmeldenummer: 89122998.1

(22) Anmeldetag: 13.12.89

(51) Int. Cl.⁵: **G03F 7/035, G03F 7/032**

(30) Priorität: 23.12.88 DE 3843506

(43) Veröffentlichungstag der Anmeldung:
27.06.90 Patentblatt 90/26

(84) Benannte Vertragsstaaten:
CH DE FR GB IT LI

(71) Anmelder: **HOECHST AKTIENGESELLSCHAFT**
**Postfach 80 03 20**
**D-6230 Frankfurt am Main 80(DE)**

(72) Erfinder: **Gersdorf, Joachim, Dr. Dipl.-Chem.**
**Lohmühlweg 17**
**D-6200 Wiesbaden(DE)**
Erfinder: **Kroggel, Matthias, Dr. Dipl.-Chem.**
**Am Flachsland 15**
**D-6233 Kelkheim(DE)**

---

(54) **Lichthärtbares elastomeres Gemisch und daraus erhaltenes Aufzeichnungsmaterial für die Herstellung von Reliefdruckplatten.**

(57) Es wird ein lichthärtbares elastomeres Gemisch beschrieben, das eine radikalisch polymerisierbare Verbindung mit mindestens einer endständigen ethylenisch ungesättigten Gruppe, einen Photopolymerisationsinitiator und als Bindemittel ein Pfropfpolymerisat enthält, dessen Pfropfgrundlage ein Polymeres aus Diolkomponenten und Diisocyanatkomponenten mit mindestens 2 Urethangruppen im Molekül ist, auf die Polymerketten aus Einheiten von Carbonsäurevinylestern mit 3 bis 20 Kohlenstoffatomen und/oder deren Verseifungsprodukten und/oder von weiteren ethylenisch ungesättigten Monomeren und/oder deren Verseifungsprodukten aufgepfropft sind und das mit einem Acylierungsreagenz in der Schmelze in homogener Phase verestert wird.

Das Gemisch ist zur Herstellung von Reliefdruckplatten, insbesondere Flexodruckplatten, geeignet. Es läßt sich mit wäßrigen alkalischen Lösungen entwickeln, zeigt aber gegenüber Wasser eine hohe Resistenz.

EP 0 374 707 A2

## Lichthärtbares elastomeres Gemisch und daraus erhaltenes Aufzeichnungsmaterial für die Herstellung von Reliefdruckplatten

Die Erfindung betrifft ein lichthärtbares, negativ arbeitendes Gemisch und ein daraus erhaltenes Aufzeichnungsmaterial, das für die Herstellung von elastischen Reliefdruckplatten geeignet ist.

Gemische der genannten Gattung sind bekannt und enthalten gewöhnlich ein elastomeres Bindemittel, eine radikalisch polymerisierbare Verbindung und einen durch aktinische Strahlung aktivierbaren Polymerisationsinitiator. Derartige Gemische, die z. B. in der DE-B 22 15 090 ( = US-A 4 423 135) beschrieben sind, lassen sich nach der Belichtung nur mit organischen Lösemitteln zum Reliefbild entwickeln.

In der US-A 4 042 386 und den DE-B 1 902 639/1 917 917 ( = US-A 3 630 746) und 2 402 808 ( = US-A 3 936 254) werden zwar wäßrig entwickelbare lichtempfindliche Aufzeichnungsmaterialien auf der Basis von teilverseiftem Polyvinylacetat zur Herstellung von Reliefdruckplatten beschrieben, jedoch wird zur Homogenisierung und Schichtausformung ein Zusatz von Wasser benötigt, der einen anschließenden Trocknungsprozeß notwendig macht. Weiterhin weisen diese Reliefdruckformen nicht die für den Flexodruck notwendige hohe Elastizität bzw. niedrige Shore-A-Härte auf.

In der DE-A 35 41 162 ( = AU 86/65535) und der EP-B 0 080 664 ( = US-A 4 493 807) werden innerlich weichgemachte teilverseifte Polyvinylacetate als Bindemittel für lichtempfindliche Aufzeichnungsmaterialien beschrieben. Diese durch Polymerisation von Vinylestern in Gegenwart von Polyalkylenoxiden und anschließende Teilverseifung erhaltenen Pfropfpolymerisate sind zwar elastischer als reine teilverseifte Polyvinylacetate, bei der Verarbeitung der entsprechenden Photopolymergemische zu flächenförmigen Aufzeichnungsmaterialien ist aber ebenfalls Wasserzusatz notwendig.

In der nicht vorveröffentlichten deutschen Patentanmeldung P 38 24 146.3 wird ein lichthärtbares elastomeres Gemisch für die Herstellung von Reliefdruckplatten beschrieben, das als elastomeres Bindemittel ein Pfropfpolymerisat enthält, welches als Pfropfgrundlage ein Polymeres aus Diolkomponenten und Diisocyanatkomponenten mit mindestens zwei Urethangruppen im Molekül aufweist, auf die Polymerketten aus Einheiten von Carbonsäurevinylestern mit 3 bis 20 Kohlenstoffatomen und/oder deren Verseifungsprodukten und/oder von weiteren ethylenisch ungesättigten Monomeren und/oder deren Verseifungsprodukten aufgepfropft sind. Die lichthärtbaren elastomeren Gemische, die diese Bindemittel enthalten, lassen sich nach dem bildmäßigen Belichten mit Wasser oder wäßrigen Lösungen entwickeln. Als verbesserungswürdig erscheint die Stabilität der Flexodruckplatte beim Druckvorgang.

Es wird angenommen, daß - da beim Drucken mit Wasser gearbeitet wird - auch die gehärteten Bereiche der Flexodruckplatte von Wasser angegriffen werden könnten.

Aufgabe war es daher, ein nicht in Wasser, aber in wäßriger alkalischer Lösung entwickelbares lichtempfindliches elastomeres Gemisch vorzuschlagen.

Gegenstand der Erfindung ist ein lichthärtbares elastomeres Gemisch, das als wesentliche Bestandteile

a) eine radikalisch polymerisierbare, mit dem Bindemittel verträgliche Verbindung mit mindestens einer endständigen ethylenisch ungesättigten Gruppe und einem Siedepunkt bei Normaldruck oberhalb 100 °C,

b) eine Verbindung oder eine Verbindungskombination, die unter Einwirkung von aktinischem Licht die Polymerisation der Verbindung (a) einzuleiten vermag und

c) ein elastomeres Bindemittel enthält, enthaltend ein hydroxylgruppenhaltiges Pfropfpolymerisat, dessen Pfropfgrundlage ein Polymeres aus Diolkomponenten und Diisocyanatkomponenten mit mindestens 2 Urethangruppen im Molekül ist, auf die Polymerketten aus Einheiten von Carbonsäurevinylestern mit 3 bis 20 Kohlenstoffatomen und/oder deren Verseifungsprodukten und/oder von weiteren ethylenisch ungesättigten Monomeren und/oder deren Verseifungsprodukten aufgepfropft sind, dadurch gekennzeichnet, daß das Pfropfpolymerisat mit einem Acylierungsreagenz in der Schmelze in homogener Phase verestert wird. Besonders bevorzugt sind teilveresterte Pfropfpolymerisate.

Als hydroxylgruppenhaltige Pfropfpolymerisate werden solche Verbindungen verstanden, die aus der Pfropfung von Carbonsäurevinylestern und/oder deren Verseifungsprodukten und gegebenenfalls weiterer Monomereinheiten aus ethylenisch ungesättigten polymerisationsfähigen Verbindungen und deren Verseifungsprodukte auf eine Pfropfgrundlage hervorgehen. Der prozentuale Anteil der aufgepfropften Komponenten beträgt 10 bis 99 Gew.-%, vorzugsweise 30 bis 90 Gew.-%, insbesondere 40 bis 80 Gew.-%, bezogen auf das Gesamtpfropfpolymerisat.

Als Pfropfungsgrundlagen werden solche genannt, die aus Polyurethanen mit mindestens 2 Urethangruppen im Molekül bestehen, wobei die Anzahl der Urethangruppen pro Pfropfungsgrundlagenmolekül nach oben keiner besonderen Begrenzung unterliegt und im allgemeinen höhere Werte als 2 hat.

Prinzipiell sind alle bei der Polyurethansynthese verwendbaren Diole einsetzbar. Bevorzugt werden cycloaliphatische Diole, wie z.B. Cyclohexandiole, sowie aliphatische Diole mit vorzugsweise 2 bis 12 C-Atomen. Bevorzugt sind ferner Polyetherdiole, z.B. Polypropylenoxide, Polybutylenoxide, Mischpolymere aus Ethylenoxid, Propylenoxid, Butylenoxid, vorzugsweise deren Blockco polymere, besonders bevorzugt sind Polyethylenoxide.

Vorzugsweise werden Polyetherdiole, insbesondere Polyethylenglykole, mit Molekulargewichten zwischen 200 und 10.000 verwendet, wobei Polyethylenglykole mit Molekulargewichten zwischen 400 und 1.500 besonders bevorzugt sind. Die Polyetherdiole werden gegebenenfalls in Kombination mit niedermolekularen aliphatischen Diolen, wie z.B. 1,4-Butandiol, 1,3-Propandiol, Ethylenglykol bzw. Diethylenglykol, eingesetzt. Bevorzugt liegt ein molares Verhältnis von Polyetherdiol zu niedermolekularem aliphatischem Diol von 1:0,1 bis 1:0,7 vor.

Als Diisocyanatkomponenten werden aromatische Diisocyanate, z.B. m- und p-Xylylendiisocyanat, Tolylen-2,4-diisocyanat, Tolylen-2,6-diisocyanat oder Gemische der beiden letzteren Isomeren, Naphthylen-1,5-diisocyanat, Diphenylmethan-4,4'-diisocyanat, Phenylbenzyl-4,4'-diisocyanat verwendet.

Bevorzugt werden aliphatische und/oder cycloaliphatische Diisocyanate eingesetzt. Bevorzugte aliphatische Diisocyanate sind z.B. solche mit 2 bis 12 C-Atomen im aliphatischen Rest, z.B. Ethylendiisocyanat, Propylendiisocyanat, Tetramethylendiisocyanat, 2,2,4-Trimethylhexamethylendiisocyanat. Bevorzugte cycloaliphatische Diisocyanate sind z.B. 1,4-Diisocyanato-cyclohexan, Dicyclohexylmethandiisocyanat und Isophorondiisocyanat. Besonders bevorzugt ist die Verwendung von Hexamethylendiisocyanat und Isophorondiisocyanat.

Das Molverhältnis von Diol- zur Diisocyanatkomponente liegt vorzugsweise zwischen 1:0,99 und 1:0,5, insbesondere zwischen 1:0,98 und 1:0,7. Die mittleren Molekulargewichte der Polyurethane liegen vorzugsweise zwischen 200 und 100.000, insbesondere zwischen 1.300 und 50.000, besonders bevorzugt zwischen 3.000 und 25.000. Zur Regelung des Molekulargewichtes bei der Herstellung der Polyurethane können Monohydroxyverbindungen, wie z.B. Methanol, Ethanol oder andere aliphatischen Alkohole, insbesondere solche der allgemeinen Formel $C_nH_{2n+2}O$ mit n = 1 bis 4, verwendet werden, aber auch halbveresterte oder halbveretherte Diole bzw. Diolkomponenten. Darüber hinaus finden zur Molekulargewichtssteuerung Monoisocyanate Verwendung.

Es ist darauf hinzuweisen, daß z.B. bei vorgegebenem Molekulargewicht für die Pfropfgrundlage die Anzahl ihrer Urethangruppen direkt von den Molekulargewichten der verwendeten Diol- bzw. Diisocyanat-Komponenten abhängt.

Zum Pfropfen auf das Polyurethan werden Carbonsäurevinylester mit 3 bis 20 C-Atomen, vorzugsweise mit 4 bis 14 C-Atomen, eingesetzt. Besonders bevorzugt werden Vinylacetat und/oder Vinylpropionat, insbesondere Vinylacetat. Bevorzugt sind ferner Gemische aus Vinylacetat und/oder Vinylpropionat und Vinylversatat. Insbesondere bei Teil- oder Vollverseifung der Produkte im Anschluß an die Pfropfpolymerisation ist beim Pfropfen die Mitverwendung von Vinylpropionat neben Vinylacetat vorteilhaft. Außerdem lassen sich copolymerisierbare Gemische aus Carbonsäurevinylestern pfropfen, vorzugsweise Gemische aus Vinylacetat und Vinylversatat, wobei der Vinylversatatanteil 0,2 bis 10 Gew.-%, vorzugsweise 0,5 bis 5 Gew.-%, bezogen auf den Vinylacetatanteil, beträgt. Auch das Pfropfen mit verschiedenen Carbonsäurevinylestern in Form von Blockcopolymeren, gegebenenfalls in Kombination mit weiteren ethylenisch ungesättigten und copolymerisationsfähigen Monomeren, kann vorteilhaft sein.

Weiterhin können die Carbonsäurevinylester auch zusammen mit anderen ethylenisch ungesättigten und copolymerisierbaren Monomeren, wie z.B. Maleinsäure, Itaconsäure, Mesaconsäure, Crotonsäure, Acrylsäure oder deren Estern, gepfropft werden.

Das Pfropfen wird unter Verwendung von Radikalketten startenden Pfropfkatalysatoren durchgeführt. Hierfür kommen vorzugsweise alle in den Monomeren, der Monomerenmischung bzw. der Monomerenlösung löslichen Radikalbildner in Betracht. Insbesondere sind zu nennen: organische Per-Verbindungen, wie Peroxide und Percarbonate und organische Azo-Verbindungen. Bevorzugt wird Azo-bis-isobutyronitril und besonders Dibenzoylperoxid. Die Pfropfreaktion wird in Gegenwart von vorzugsweise 0,013 bis 1,3 mol-%, insbesondere 0,026 bis 0,27 mol-%, Radikale bildendem Katalysator, bezogen auf die Monomerenmenge, durchgeführt.

Die erhaltenen hydroxylgruppenhaltigen Pfropfpolymerisate lassen sich durch Hydrolyse, Alkoholyse oder Umesterung in teil- oder vollverseifte Produkte überführen, wobei der Hydrolysegrad mindestens 1 mol-%, vorzugsweise 70 bis 99 mol-%, bezogen auf die Molzahl verseifbarer Monomereinheiten im Pfropfpolymerisat, beträgt.

Das Verfahren zur Herstellung der hydroxylgruppenhaltigen Pfropfpolymerisate wird in der deutschen Patentanmeldung P 37 32 089 beschrieben.

Das Verfahren, in dem die in der P 37 32 089 genannten hydroxylgruppenhaltigen Pfropfpolymerisate mit einem Acylierungsreagenz umgesetzt werden, sowie die daraus entstehenden Produkte, werden in der gleichzeitig eingereichten deutschen Patentanmeldung P 38 43 505.5 beschrieben.

Als Acylierungsreagenzien zur Herstellung dieser hydroxylgruppenhaltigen Pfropfpolymerisate werden dort insbesondere Carbonsäureanhydride genannt. Vorzugsweise werden Alkan-, Alken- und/oder Acrylcarbonsäureanhydride mit 2 bis 12 C-Atomen verwendet. Zu nennen sind z.B.: Bernsteinsäureanhydrid, Maleinsäureanhydrid, Citraconsäureanhydrid, Glutarsäureanhydrid, Phthalsäureanhydrid, Cis-4-cyclohexen-1,2-dicarbonsäureanhydrid, Acrylsäureanhydrid, Methacrylsäureanhydrid, Crotonsäureanhydrid und Itaconsäureanhydrid. Auch Mischungen von Carbonsäureanhydriden können eingesetzt werden.

Der Grad der Umsetzung von freien Hydroxylgruppen des Pfropfpolymerisats mit den genannten Acylierungsreagenzien zur Herstellung des veresterten Produkts hängt von dessen gewünschten Eigenschaften ab, insbesondere der Lösungseigenschaften des Produkts. Es können sowohl verseifte wie auch teilverseifte Pfropfpolymerisate als Ausgangsmaterial für die Veresterungsreaktion eingesetzt werden. Unter teilverseiften Pfropfpolymerisaten versteht man im allgemeinen Produkte, die zu 80 bis 90 mol-% verseift sind (Hydrolysegrad).

Weniger üblich sind teilverseifte Produkte, die einen Hydrolysegrad von 50 bis 60 % aufweisen.

Im allgemeinen läßt sich der Umsetzungsgrad des hydroxylgruppenhaltigen Pfropfpolymerisates mit dem Acylierungsreagenz in der Weise beschreiben, daß das Gewichtsverhältnis von Pfropfpolymerisat zu Acylierungsreagenz, insbesondere bei Verwendung eines Carbonsäureanhydrids, bei 1:0,01 bis 1:5, bevorzugt bei 1:0,05 bis 1:2 liegt. Als Grundlage dieser Angabe dienen die teilverseiften Pfropfpolymerisate, die zu 80 bis 90 % verseift sind.

Letztendlich muß die Reaktion in der Weise eingestellt werden, daß das resultierende Produkt Anwendung als Bindemittel in einem lichtempfindlichen Gemisch finden kann. Hierzu gehört, daß die Entwicklung der Schicht in wäßrigem Alkali (insbesondere in 1%iger wäßriger Sodalösung) möglich ist, aber ebenso daß die entwickelte Reliefform nicht durch Wasser zerstört wird.

Das mittlere Molekulargewicht der zumindest teilweise veresterten, hydroxylgruppenhaltigen Pfropfpolymerisate liegt vorzugsweise zwischen 200 und 100.000, insbesondere zwischen 1.300 und 50.000, besonders bevorzugt zwischen 3.000 und 25.000. Die Säurezahl des Produkts soll im Bereich von 80 bis 250 mg KOH/g Polymeres, insbesondere von 100 bis 200 mg KOH/g Polymeres, liegen.

Nach dem in der gleichzeitig eingereichten deutschen Patentanmeldung P 38 43 505.5 genannten Verfahren wird das hydroxylgruppenhaltige Pfropfpolymerisat entweder ohne Acylierungsreagenz oder auch gleichzeitig mit dem Acylierungsreagenz, vorzugsweise ohne Zusatz eines Lösemittels, aufgeschmolzen. Als Acylierungsreagenzien werden vorzugsweise Carbonsäureanhydride verwendet. Die Schmelztemperatur liegt im allgemeinen bei 80 bis 200° C, insbesondere bei 100 bis 180° C, sowie besonders bevorzugt bei 120 bis 160° C.

Die Reaktion wird ohne Zusatz eines Katalysators, der zur Färbung des Produktes führen kann, insbesondere von Aminen, durchgeführt. Die Reaktionszeit kann extrem kurz angesetzt werden und liegt im Bereich von einigen Minuten. Vorzugsweise ist die Reaktion schon nach einer Reaktionszeit unter 10 min beendet.

Die Veresterung kann, auch wenn die Zugabe des Acylierungsreagenzes nicht gleichzeitig mit dem Aufschmelzen erfolgte, in einem für die Durchführung von thermoplastischen Reaktionen üblichen Reaktionsgefäß bzw. Verarbeitungsgerät stattfinden. Solche Geräte sind beispielsweise: Zweiwalzenstühle, Knetmaschinen und Extrudiereinrichtungen. Überraschenderweise konnte gefunden werden, daß z.B. bei einer geplanten maximal 50%igen Umsetzung der im Pfropfpolymerisat enthaltenen sekundären Hydroxylgruppen (durch Anwendung eines entsprechenden Molverhältnisses der Edukte), die Reaktion auch ohne Verwendung des Katalysators schon nach wenigen Minuten vollständig abgelaufen ist. Das Produkt wird in homogener Phase erhalten. Es weist keine sonst in Kauf zu nehmenden örtlich unterschiedlichen Umsatzgrade im Pfropfpolymerisat auf; das Produkt hat demzufolge einheitlich reagiert und ist daher reproduzierbar herzustellen.

Die erfindungsgemäßen lichtempfindlichen Gemische enthalten im allgemeinen 20 - 95, vorzugsweise 30 - 70 Gew.-% Bindemittel. Sie enthalten weiterhin mindestens eine radikalisch polymerisierbare olefinisch ungesättigte Verbindung sowie mindestens einen Photoinitiator.

Geeignete Monomere mit einer oder mehreren polymerisierbaren olefinischen Doppelbindungen sind insbesondere Ester und Amide von Acryl- und Methacrylsäure. Beispiele sind die verträglichen Mono- und Diacrylate und -methacrylate von ein- oder mehrwertigen Alkoholen wie Ethylenglykol, Di-, Tri-, Tetra- oder Polyethylenglykolen, letztere bevorzugt mit 10 bis 15 Ethylenglykoleinheiten, 1,3-Propandiol, Glycerin, 1,1,1-Trimethylolpropan, 1,2,4-Butantriol oder Pentaerythrit, z. B. Ethylenglykol-monomethacrylat, 1,3-Propandiolmonomethacrylat, Glycerinmono- und -diacrylat, 1,2,4-Butantriolmonomethacrylat, Pentaerythrittriacrylat, Polyethylenglykolmethyletheracrylat, Tetradecaethylenglykol-dimethacrylat oder der Triether aus Glycerin und 3 mol N-Methylolacrylamid oder -methacrylamid. Die Menge an Monomeren liegt im allgemeinen bei etwa 5 bis 70, bevorzugt bei etwa 10 bis 50 Gew.-% der nichtflüchtigen Betandteile des Gemischs.

Als Photoinitiatoren für die erfindungsgemäßen Gemische kommen die bekannten Verbindungen in Frage, die eine hinreichende thermische Stabilität bei der Verarbeitung der Aufzeichnungsmaterialien sowie eine hinreichende Radikalbildung bei Belichtung unter Initiierung der Polymerisation der Monomeren aufweisen. Sie sollen Licht im Wellenlängenbereich von ca. 250 bis ca. 500 nm unter Bildung von Radikalen absorbieren. Beispiele geeigneter Photoinitiatoren sind Acyloine und deren Derivate wie Benzoin, Benzoinalkylether, z. B. Benzoinisopropylether, vicinale Diketone und deren Derivate, z. B. Benzil, Benzilacetale wie Benzildimethylketal, Fluorenone, Thioxanthone, Mehrkernchinone, Acridine und Chinoxaline; ferner Trichlormethyl-s-triazine, 2-Halogenmethyl-4-styryl-1,3,4-oxadiazolderivate, mit Trichlormethylgruppen substituierte Halogenoxazole, Trihalogenmethylgruppen enthaltende Carbonylmethylenheterocyclen gemäß DE-A 33 33 450, Acylphosphinoxid verbindungen, wie sie z. B. in der DE-A 31 33 419 beschrieben sind, und andere phosphorhaltige Photoinitiatoren, z. B. die in der älteren deutschen Patentanmeldung P 38 27 735.2 beschriebenen 6-Acyl-(6H)-dibenz[c,e][1,2]-oxaphosphorin-6-oxide, insbesondere das 6-(2,4,6)-Trimethylbenzoyl)-(6H)-dibenz-[c,e] [1,2] oxaphosphorin-6-oxid. Die Photoinitiatoren lassen sich auch in Kombination miteinander oder mit Coinitiatoren bzw. Aktivatoren verwenden, z. B. mit Michlers Keton und seinen Derivaten oder 2-Alkyl-anthrachinonen. Die Menge an Photoinitiator beträgt im allgemeinen etwa 0,01 bis 10, bevorzugt etwa 0,5 bis 5 Gew.-% des Aufzeichnungsmaterials.

Oft ist es von Vorteil, dem Aufzeichnungsmaterial noch weitere Hilfs- und Zusatzstoffe zuzugeben, z. B. Inhibitoren der thermischen Polymerisation wie Hydrochinon und seine Derivate, 2,6-Ditert.-butyl-p-kresol, Nitrophenole, Nitrosamine wie N-Nitrosodiphenylamin oder Salze des N-Nitrosocyclohexylhydroxylamins, z. B. dessen Alkali- oder Aluminiumsalze. Weitere übliche Zusätze sind Farbstoffe, Pigmente, Verarbeitungshilfsmittel und Weichmacher.

Die erfindungsgemäßen Gemische lassen sich für die Herstellung von Relief- und Flexodruckplatten durch Gießen aus Lösung oder Extrudieren und Kalandrieren zu Schichten einer Dicke von 0,02 bis 6, vorzugsweise von 0,2 bis 2 mm, ausformen. Die Schicht kann auf die Oberfläche eines geeigneten Trägers laminiert oder eine Lösung der erfindungsgemäßen Gemische kann auf einen Schichtträger aufgebracht werden.

Außer für die Herstellung von Reliefdruckplatten können die erfindungsgemäßen Gemische auch z. B. zur Herstellung von Flachdruckplatten, Tiefdruckzylindern, Siebdruckschablonen und Photoresists verwendet werden.

Geeignete Träger sind je nach Verwendungszweck z. B. Polyesterfolien, Stahl- oder Aluminiumbleche, Kupferzylinder, Siebdruckschablonenträger, Schaumstofflagen, gummielastische Träger oder Leiterplatten. Es kann auch vorteilhaft sein, auf die lichtempfindliche Aufzeichnungsschicht eine Deck- bzw. Schutzschicht, z. B. eine dünne Schicht aus Polyvinylalkohol, oder eine abziehbare Deckfolie, z. B. aus Polyethylenglykolterephtha lat, aufzubringen. Weiterhin kann eine Vorbeschichtung des Trägers vorteilhaft sein. Die zusätzliche Schicht zwischen dem Träger und der lichtempfindlichen Schicht kann z. B. als Lichthofschutzschicht oder als Haftschicht wirksam sein.

Die erfindungsgemäßen Aufzeichnungsmaterialien können bildmäßig mit aktinischem Licht aus Lichtquellen wie Quecksilberdampflampen oder Leuchtstoffröhren belichtet werden, wobei die emittierte Wellenlänge bevorzugt zwischen 300 und 420 nm liegt. Das Entfernen der unbelichteten und unvernetzten Schichtanteile kann durch Sprühen, Waschen oder Bürsten mit wäßrigen alkalischen Lösungen, z. B. von Netz- oder Emulgiermitteln, erfol gen. Gegenüber Wasser sind die vernetzten Schichtbestandteile resistent. Der Lösung können ferner kleine Mengen Entschäumer oder mit Wasser mischbare organische Lösemittel, z. B. niedere aliphatische Alkohole, zugesetzt werden. Der Mengenanteil an organischen Lösemitteln ist im allgemeinen kleiner als 10 %, bevorzugt kleiner als 5 %. Zweckmäßig werden die entwickelten Reliefformen bei Temperaturen bis 120 °C getrocknet und gegebenenfalls gleichzeitig oder danach mit aktinischem Licht nachbelichtet.

Die erfindungsgemäßen Aufzeichnungsmaterialien eignen sich besonders zur Herstellung von Druckformen, vor allem Hoch- oder Reliefdruckformen, die besonders für den Flexodruck geeignet sind.

Die Erfindung wird durch die nachstehenden Beispiele erläutert. Die Grenzviskositätszahlen $J_0$ - [ml/g] wurden bei 25 °C im Ostwaldviskosimeter ermittelt. Die Hydrolysegrade (in mol-%) beziehen sich auf die hydrolysierbaren Monomereinheiten im unverseiften Pfropfpolymerisat.

Herstellungsbeispiele:

Beispiel 1

Herstellung des hydroxylgruppenhaltigen Pfropfpolymerisats

a) Synthese der Polyurethan-Pfropfgrundlage

3.000 g Polyethylenglykol 600 und 193,1 g 1,4-Butandiol werden gemeinsam mit 1,5 ml 1,4-Dimethylpiperazin auf 75° C erwärmt und innerhalb von 6 Stunden mit 1.428,2 g Isophorondiisocyanat versetzt. Anschließend läßt man zwei Stunden bei 80° C nachreagieren.

Die Grenzviskosität $J_o$ in Methanol des in dieser Weise hergestellten Polyurethans beträgt 10,6 ml/g.

b) Synthese des Pfropfpolymerisates

1.500 g der Polyurethan-Pfropfgrundlage werden auf 80° C erwärmt und unter Rühren mit einem Gemisch aus 3.480 g Vinylacetat und 26,1 g Dibenzoylperoxid (75%ig) innerhalb von 5 Stunden versetzt. Nach 45 Minuten Weiterreagieren bei 80° C wird das nicht umgesetzte Vinylacetat durch azeotrope Destillation mit Methanol entfernt. Die Grenzviskosität $J_o$ in THF des in dieser Weise hergestellten Pfropfpolymerisats beträgt 17,5 ml/g.

c) Synthese des hydroxylgruppenhaltigen Pfropfpolymerisates

9.178 g einer 50%igen methanolischen Lösung des Pfropfpolymerisats werden bei Raumtemperatur mit 172,1 g einer 10%igen methanolischen NaOH und 172,1 g Wasser versetzt. Die Mischung geliert nach einiger Zeit und wird anschließend granuliert. Man schlämmt das erhaltene Granulat in Methanol auf und setzt eine zur NaOH äquivalente Menge an Essigsäure zu. Das Produkt wird abfiltriert, mehrmals mit Methanol gewaschen und getrocknet. Die Grenzviskosität $J_o$ in Wasser beträgt 10,1 ml/g, der Hydrolysegrad 85,8 % und der Anteil an Vinylalkoholgruppen 42,2 %.

Beispiel 2

Veresterung des hydroxylgruppenhaltigen Pfropfpolymerisates

Nach dem Aufschmelzen von 100 g des in Beispiel 1c) beschriebenen teilverseiften Pfropfpolymerisates bei 140° C in einem Zweiwalzenstuhl werden 47,8 g Bernsteinsäureanhydrid bei dieser Temperatur zugegeben. Nach 6 min Reaktion bei 140° C ist die Reaktion beendet; es wird ein farbloses homogenes Produkt erhalten, das eine Säurezahl von 181 mg KOH/g Polymerisat aufweist. Das Produkt ist in Wasser nicht löslich, es löst sich aber klar sowohl in einer 1%igen wäßrigen Sodalösung wie auch in Ethanol.

Beispiel 3

Veresterung des hydroxylgruppenhaltigen Pfropfpolymerisates

50 g des in Beispiel 1c) beschriebenen teilverseiften Pfropfpolymerisates werden bei 140° C in einem Zweiwalzenstuhl aufgeschmolzen. Anschließend werden bei 140° C 23,5 g Maleinsäureanhydrid und 0,8 g 2,6-Ditert.-butyl-4-methylphenol zugegeben. Nach 4 min ist die Reaktion beendet. Das erhaltene Produkt ist farblos und weist eine Säurezahl von 133 mg KOH/g Polymerisat auf. Es löst sich in Wasser nur schwer unter Trübung, dagegen wird in 1%iger wäßriger Sodalösung oder in Ethanol eine klare Lösung erhalten.

Beispiel 4

Veresterung des hydroxylgruppenhaltigen Pfropfpolymerisates

200 g des in Beispiel 1c) beschriebenen teilverseiften Pfropfpolymerisates, 94 g Maleinsäureanhydrid und 3,2 g 2,6-Di-tert.-butyl-4-methylphenol werden gemischt und anschließend gemeinsam in einem gegenläufigen Zweischneckenextruder mit einem Verhältnis von Schneckenlänge zu Schneckendurchmesser von 15 bei 140° C und einer Verweilzeit von 3 min extrudiert. Das farblose homogene Extrudat weist eine Säurezahl von 142 mg KOH/g Polymerisat auf und zeigt darüber hinaus die gleichen Eigenschaften wie das Polymerisat aus Beispiel 3.

Anwendungsbeispiele:

Beispiel 1

73,15 Gt des mit Bernsteinsäureanhydrid umgesetzten hydroxylgruppenhaltigen Pfropfpolymeren (Beispiel 2) werden mit 20,0 Gt Triethylenglycoldimethacrylat, 4,0 Gt Trimethylolpropantriacrylat, 2,0 Gt Benzildimethylketal, 0,8 Gt 2,6-Di-tert.-butyl-4-methylphenol und 0,05 Gt 2,4-Dihydroxybenzophenon vorgemischt und in einem Einschneckenextruder (Brabender Plasticorder) bei 140° C und 150 U/min über eine Breitschlitzdüse zu einer transparenten Schmelze extrudiert. Das Extrudat wird in einer Plattenpresse zwischen einer 0,125 mm dicken Polyesterfolie und einem 0,3 mm dikken anodisch oxidiertem Aluminiumblech, das mit einer Polyurethanhaftschicht versehen ist, bei 100° C und 15 bar eine Minute zu einer 0,6 mm dicken Photopolymerschicht heißgepreßt. Nach Abziehen der Polyesterfolie wird fünf Minuten bildmäßig mit einem handelsüblichen UVA-Flachbelichter belichtet und für zwei Minuten mit 1%iger wäßriger Sodalösung zu einer Reliefdruckplatte mit der Shore-A-Härte 90 entwickelt, die gegenüber Wasser (Lagerung 24 Stunden bei 25° C) resistent ist.

Wird mit reinem Wasser entwickelt, so kann nur eine unvollständig entwickelte Reliefschicht erhalten werden.

### Beispiel 2 (Vergleichsbeispiel)

73,15 Gt eines nicht mit einem Carbonsäureanhydrid umgesetzten hydroxylgruppenhaltigen Pfropfpolymerisats (nach Beispiel 1c) werden analog zu Beispiel 1 zu einer Photopolymerschicht verarbeitet. Nach Belichtung wird mit Wasser entwickelt. Die erhaltene Reliefdruckplatte wird bei mehrstündiger Lagerung in auf 25° C temperiertem Wasser zerstört.

### Beispiel 3

57,8 Gt des in Beispiel 3 beschriebenen Bindemittels werden mit 35,8 Gt 2-Hydroxypropylmethacrylat, 4,0 Gt Trimethylolpropantriacrylat, 2,0 Gt Benzildimethylketal und 0,8 Gt 2,6-Di-tert.-butyl-4-methylphenol auf einem Zweiwalzenstuhl bei 130° C 2 Minuten homogenisiert, und die Mischung analog zu Beispiel 1 zu einer Reliefdruckplatte mit einer Shore-A-Härte von 92 verarbeitet. Die Platte ließ sich gut mit 1%iger wäßriger Sodalösung entwickeln. Daneben ist die Reliefschicht gegenüber reinem Wasser (Lagerung 24 Stunden bei 25° C) resistent.

### Beispiel 4 (Vergleichsbeispiel)

57,8 Gt eines nicht mit einem Carbonsäureanhydrid umgesetzten hydroxylgruppenhaltigen Pfropfpolymerisats (nach Beispiel 1c) werden analog zu Beispiel 3 zu einer Photopolymerschicht verarbeitet. Nach Belichtung wird mit Wasser entwickelt. Die erhaltene Reliefdruckplatte wird bei mehrstündiger Lagerung in auf 25° C temperiertem Wasser

zerstört.

### Ansprüche

1. Lichthärtbares elastomeres Gemisch, das als wesentliche Bestandteile

a) eine radikalisch polymerisierbare, mit dem Bindemittel verträgliche Verbindung mit mindestens einer endständigen ethylenisch ungesättigten Gruppe und einem Siedepunkt bei Normaldruck oberhalb 100° C,

b) eine Verbindung oder eine Verbindungskombination, die unter Einwirkung von aktinischem Licht die Polymerisation der Verbindung (a) einzuleiten vermag und

c) ein elastomeres Bindemittel enthält, enthaltend ein hydroxylgruppenhaltiges Pfropfpolymerisat, dessen Pfropfgrundlage ein Polymeres aus Diolkomponenten und Diisocyanatkomponenten mit mindestens 2 Urethangruppen im Molekül ist, auf die Polymerketten aus Einheiten von Carbonsäurevinylestern mit 3 bis 20 Kohlenstoffatomen und/oder deren Verseifungsprodukten und/oder von weiteren ethylenisch ungesättigten Monomeren und/oder deren Verseifungsprodukten aufgepfropft sind, dadurch gekennzeichnet, daß das Polymere mit einem Acylierungsreagenz in der Schmelze in homogener Phase verestert wird.

2. Lichthärtbares Gemisch nach Anspruch 1, dadurch gekennzeichnet, daß das Pfropfpolymerisat ein teilverestertes Produkt darstellt.

3. Lichthärtbares Gemisch nach den Ansprüchen 1 oder 2, dadurch gekennzeichnet, daß das teilveresterte Pfropfpolymerisat aus einem zu 80 bis 90 mol-% teilverseiften hydroxylgruppenhaltigen Pfropfpolymerisat durch Umsetzung mit dem Acylierungsreagenz hergestellt worden ist.

4. Lichthärtbares Gemisch nach Anspruch 3, dadurch gekennzeichnet, daß das Gewichtsverhältnis des hydroxylgruppenhaltigen Pfropfpolymerisats zum Acylierungsreagenz von 1:0,01 bis 1:5 reicht.

5. Lichthärtbares Gemisch nach einem oder mehreren der Ansprüche 1 bis 4, dadurch gekennzeichnet, daß als Acylierungsreagenz ein Carbonsäureanhydrid verwendet wird.

6. Lichthärtbares Gemisch nach einem oder mehreren der Ansprüche 1 bis 5, dadurch gekennzeichnet, daß das Polymerisat ein mittleres Molekulargewicht von 200 bis 100.000, insbesondere von 1.300 bis 50.000 aufweist.

7. Lichthärtbares Gemisch nach einem oder mehreren der Ansprüche 1 bis 6, dadurch gekennzeichnet, daß das Polymerisat eine Säurezahl von 80 bis 250 mg KOH/g Polymeres aufweist.

8. Lichthärtbares Gemisch nach einem oder mehreren der Ansprüche 1 bis 7, dadurch gekennzeichnet, daß das Pfropfpolymerisat 10 bis 99 Gew.-% aufgepfropfte Bestandteile enthält.

9. Lichthärtbares Gemisch nach Anspruch 1, dadurch gekennzeichnet, daß das Diisocyanat ein aliphatisches oder cycloaliphatisches Diisocyanat ist.

10. Lichthärtbares Gemisch nach Anspruch 1, dadurch gekennzeichnet, daß das Diol ein Gemisch aus einem Polyetherdiol und einem monomeren Diol ist.

11. Lichthärtbares Gemisch nach Anspruch 10, dadurch gekennzeichnet, daß 0,1 bis 0,7 mol monomeres Diol je mol Polyetherdiol eingesetzt werden.

12. Lichthärtbares Gemisch nach Anspruch 1, dadurch gekennzeichnet, daß das Molverhältnis von Diol- zu Diisocyanatkomponente 1 : 0,99 bis 1 : 0,5 beträgt.

13. Lichthärtbares Gemisch nach Anspruch 1, dadurch gekennzeichnet, daß Einheiten von Vinylestern mit 4 bis 12 Kohlenstoffatomen aufgepfropft werden.

14. Lichthärtbares Gemisch nach Anspruch 1, dadurch gekennzeichnet, daß das Pfropfpolymerisat zu 70 bis 99 mol-%, bezogen auf die Zahl verseifbarer Monomereinheiten, verseift ist.

15. Lichthärtbares Gemisch nach Anspruch 1, dadurch gekennzeichnet, daß die radikalisch polymerisierbare Verbindung ein Acryl- oder Methacrylsäureester eines ein- oder mehrwertigen Alkohols oder ein Acryl- oder Methacrylsäureamid ist.

16. Lichthärtbares Gemisch nach Anspruch 1, dadurch gekennzeichnet, daß es 20 bis 95 Gew.-% Pfropfpolymerisat, 5 bis 70 Gew.-% polymerisierbare Verbindungen und 0,01 bis 10 Gew.-% Photopolymerisationsinitiator enthält.

17. Lichthärtbares Aufzeichnungsmaterial mit einem Schichtträger und einer lichthärtbaren Schicht, dadurch gekennzeichnet, daß die lichthärtbare Schicht aus einem Gemisch gemäß einem der Ansprüche 1 bis 16 besteht.